# EUROPÄISCHE PATENTANMELDUNG

(11) **EP 1 936 709 A2**
(43) Veröffentlichungstag der Anmeldung: **25.06.2008**
(21) Anmeldenummer: 07120337.6
(22) Anmeldetag: 09.11.2007
(51) Int. Cl.: H01L 41/053

(54) **Piezoelektrischer Aktor**

(30) Priorität: 21.12.2006 DE 102006060651
(71) Anmelder: ROBERT BOSCH GMBH, 70442 Stuttgart (DE)
(72) Erfinder: Mattes, Patrick, 70569 Stuttgart (DE)

(57) **Zusammenfassung**

Ein piezoelektrischer Aktor (2) für ein Brennstoffeinspritzventil (1) weist einen Aktorkörper (13) und ein an den Aktorkörper (13) angefügtes Übergangsstück (23, 24) auf. Der Aktorkörper (13) weist eine Vielzahl von keramischen Schichten (25, 26, 27) und eine Vielzahl von zwischen diesen angeordnete Elektrodenschichten (28, 29) auf. Der Aktorkörper (13) ist mit einer metallischen Schutzfolie (41) umwickelt. Außerdem ist eine Ummantelung (44) vorgesehen, die den mit der Schutzfolie (41) umwickelten Aktorkörper (13) sowie teilweise das Übergangsstück (23, 24) ummantelt. Die Ummantelung (44) ist dabei aus einem teilelastischen Kunststoff gebildet, um eine Dehnung des Aktorkörpers (13) zu ermöglichen und gegebenenfalls eine Vorspannung des Aktorkörpers (13) zu gewährleisten.

## Beschreibung

### Stand der Technik

Die Erfindung betrifft einen piezoelektrischen Aktor für ein Brennstoffeinspritzventil und ein Brennstoffeinspritzventil mit solch einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der WO 03/026033 A1 ist eine Vorrichtung mit einem piezoelektrischen Aktor für eine Einspritzeinrichtung für einen Dieselmotor mit mehreren Zylindern bekannt. Der piezoelektrische Aktor der bekannten Vorrichtung weist zwei Stirnflächen sowie zwei elektrisch leitfähige Kontaktbahnen auf, deren jede den Aktor ausgehend von einer Stirnfläche durchquert. Ferner sind zwei metallische Platten vorgesehen, deren jede an einer Stirnfläche des Aktors angeordnet ist, zwischen denen der Aktor eingespannt ist. Dabei sind zwischen den Stirnflächen und den zugeordneten Platten elektrisch isolierende Isolierschichten vorgesehen, die gespritzt oder durch Emaillieren ausgebildet sind. Die Isolierschichten haben den Zweck, einen Kurzschluss zwischen elektrisch leitfähigen Komponenten des Aktors und den Platten zu vermeiden.

Die aus der WO 03/026033 A1 bekannte Vorrichtung für eine Einspritzanlage für einen Dieselmotor hat den Nachteil, dass die Ausgestaltung relativ aufwändig ist und keine zuverlässige Beständigkeit gegenüber Medien, die insbesondere unter hohem Druck stehen können, gewährleistet ist. Der Anwendungsbereich der bekannten Vorrichtung ist daher begrenzt.

### Offenbarung der Erfindung

### Vorteilhafte Wirkungen

Der erfindungsgemäße piezoelektrische Aktor mit den Merkmalen des Anspruchs 1 und das erfindungsgemäße Brennstoffeinspritzventil mit den Merkmalen des Anspruchs 11 haben demgegenüber den Vorteil, dass eine Medienbeständigkeit des piezoelektrischen Aktors gewährleistet ist. Insbesondere kann eine gute Beständigkeit gegenüber Brennstoffen gewährleistet werden.

Durch die in den Unteransprüchen aufgeführten Maßnahmen sind vorteilhafte Weiterbildungen des im Anspruch 1 angegebenen piezoelektrischen Aktors und des im Anspruch 11 angegebenen Brennstoffeinspritzventils möglich.

In vorteilhafter Weise kann der piezoelektrische Aktor so ausgestaltet sein, dass sowohl eine Beständigkeit gegenüber verschiedenen Brennstoffen als auch gegenüber wechselnden Drücken und Temperaturen gegeben ist. Spezielle Kapselungen des piezoelektrischen Aktors, beispielsweise mit einer Metallhülse und zusätzlicher Membran, können dann entfallen, so dass eine kostengünstige Herstellung des piezoelektrischen Aktors und des Brennstoffeinspritzventils mit solch einem piezoelektrischen Aktor möglich ist. Ferner kann eine gewisse mechanische Widerstandsfähigkeit gewährleistet werden, so dass die Zuverlässigkeit auch nach Lagerung, Transport und Montage gewährleistet ist.

Ferner kann durch die Ummantelung des mit der Schutzfolie umwickelten Aktorkörpers eine vorteilhafte Abdichtung der Folie an den Endstellen erzielt werden, wobei die Ummantelung einen zusätzlichen mechanischen Schutz der Schutzfolie gewährleistet. Durch die Schutzfolie kann der Aktorkörper zuverlässig gegenüber korrosiven Medien, insbesondere Wasser enthaltenden Dieselbrennstoff, geschützt werden, so dass sich in der Summe ein zuverlässiger mechanischer und chemischer Schutz des Aktorkörpers des piezoelektrischen Aktors ergibt.

In vorteilhafter Weise umfasst die Ummantelung ein Grundmaterial auf der Basis eines teilelastischen Kunststoffs. Dadurch kann die Ummantelung, die bei der Betätigung des piezoelektrischen Aktors auftretenden Dehnungen und Verkürzungen des Aktorkörpers nachvollziehen. Ferner kann beim Aufbringen der Ummantelung, die beispielsweise durch Umspritzen des mit der Schutzfolie umwickelten Aktorkörpers erfolgen kann, der Aktorkörper vorgespannt werden. Ein zusätzliches Vorspannelement, wie eine Rohr- oder Schraubenfeder, die zum Vorspannen des Aktorkörpers dient, kann dann vereinfacht werden oder sogar ganz entfallen.

Vorteilhaft ist es, dass die Ummantelung wärmeleitende Zusatzstoffe aufweist, die dem Grundmaterial zugesetzt oder in das Grundmaterial eingebettet sind. Die wärmeleitenden Zusatzstoffe verbessern die Wärmeleitung der Ummantelung, so dass die bei der Betätigung des piezoelektrischen Aktors auftretende Erwärmung des Aktorkörpers abgeführt werden kann, zum Beispiel an den die Ummantelung umströmenden Brennstoff. Die wärmeleitenden Zusatzstoffe können aus einem metallischen Material, aus einem Silicium oder dergleichen gebildet sein.

Vorteilhaft ist es, dass die Schutzfolie um den Aktorkörper und um an den Aktorkörper angrenzende Teile von Übergangsstücken gewickelt ist und dass die Ummantelung den mit der Schutzfolie umwickelten Aktorkörper, die mit der Schutzfolie umwickelten Teile der Übergangsstücke und weitere Teile der Übergangsstücke ummantelt. Die Übergangsstücke können dabei durch den Aktorkopf und den Aktorfuß des piezoelektrischen Aktors gebildet sein. Diese Ausgestaltung hat den Vorteil, dass eine zuverlässige Abdichtung der Endabschnitte der Schutzfolie im Bereich der Teile des Übergangsstücks gewährleistet ist. Ferner wird ein vorteilhaftes Aktormodul durch den mittels der Ummantelung gebildeten fixierten Verband gebildet. Der Aktorkörper des piezoelektrischen Aktors kann während der Montage des Aktormoduls vorgespannt werden, so dass der Einbau des piezoelektrischen Aktors, insbesondere eine Montage des Brennstoffeinspritzventils, vereinfacht ist.

In vorteilhafter Weise ist die Schutzfolie als wärmeleitende Schutzfolie ausgebildet, wobei die Schutzfolie beispielsweise aus einem oder mehreren Metallen gebildet sein kann. Dadurch ist eine gute Wärmeleitung von dem Aktorkörper zu der Ummantelung gewährleistet. Ferner kann durch die metallische Schutzfolie eine hohe Widerstandsfähigkeit gegenüber Brennstoffen gewährleistet werden. Ferner ist es vorteilhaft, dass zwischen der metallischen Schutzfolie und dem Aktorkörper eine elektrisch isolierende Beschichtung vorgesehen ist, die vorzugsweise auf eine Außenfläche des Aktorkörpers aufgebracht ist. Eine solch elektrisch isolierende Beschichtung kann beispielsweise durch einen Lack mit einer Dicke aus einem Bereich von etwa 100 µm bis etwa 200 µm gebildet sein.

### Kurze Beschreibung der Zeichnungen

Ein bevorzugtes Ausführungsbeispiel der Erfindung ist in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Ausführungsbeispiel eines Brennstoffeinspritzventils mit einem piezoelektrischen Aktor in einer schematischen, axialen Schnittdarstellung;
Fig. 2 einen Schnitt durch den in Fig. 1 dargestellten piezoelektrischen Aktor entlang der mit II bezeichneten Schnittlinie und
Fig. 3 den in Fig. 2 mit III bezeichneten Ausschnitt des piezoelektrischen Aktors in einer detaillierten Darstellung.

### Ausführungsformen der Erfindung

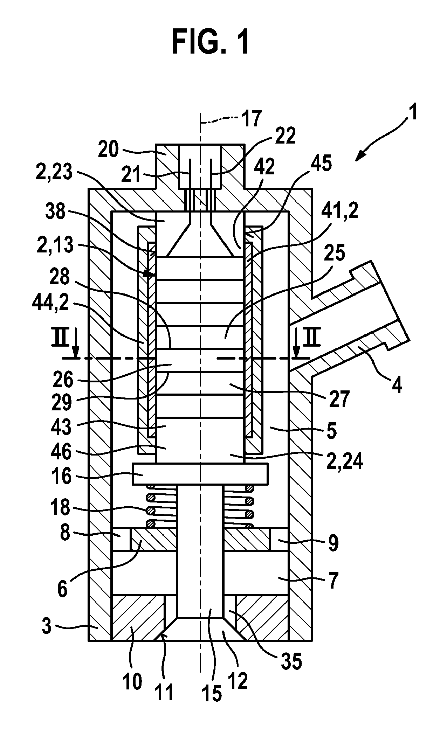

Fig. 1 zeigt ein Brennstoffeinspritzventil 1 mit einem piezoelektrischen Aktor 2 entsprechend einem Ausführungsbeispiel der Erfindung. Das Brennstoffeinspritzventil 1 kann als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße piezoelektrische Aktor 2 eignen sich jedoch auch für andere Anwendungsfälle.

Das Brennstoffeinspritzventil 1 weist ein Ventilgehäuse 3 auf, an dem ein Brennstoffeinlassstutzen 4 ausgebildet ist. An den Brennstoffeinlassstutzen 4 ist eine Brennstoffleitung anschließbar, um Brennstoff von einer Hochdruckpumpe, beispielsweise über ein Common-Rail, in einen im Inneren des Ventilgehäuses 3 vorgesehenen Aktorraum 5 einzuleiten. Der Aktorraum 5 ist durch ein Gehäuseteil 6 begrenzt und von einem ebenfalls im Inneren des Ventilgehäuses 3 vorgesehenen Brennstoffraum 7 getrennt. In dem Gehäuseteil 6 sind Durchlassöffnungen 8, 9 ausgebildet, um den über den Brennstoffeinlassstutzen 4 in den Aktorraum 5 geführten Brennstoff in den Brennstoffraum 7 zu leiten.

An einem mit dem Ventilgehäuse 3 verbundenen Ventilsitzkörper 10 ist eine Ventilsitzfläche 11 ausgebildet, die mit einem Ventilschließkörper 12 zu einem Dichtsitz zusammenwirkt. Der Ventilschließkörper 12 ist mittels einer Ventilnadel 15 betätigbar, wobei in dem dargestellten Ausführungsbeispiel der Ventilschließkörper 12 einstückig mit der Ventilnadel 15 ausgebildet ist. Über die Ventilnadel 15 ist der Ventilschließkörper 12 mit einer im Aktorraum 5 vorgesehenen Druckplatte 16 verbunden. Das Gehäuseteil 6 führt die Ventilnadel 15 in Richtung einer Achse 17 des Brennstoffeinspritzventils 1. Ferner ist eine Ventilfeder 18 vorgesehen, die einerseits an dem Gehäuseteil 6 und andererseits an der Druckplatte 16 anliegt. Die Ventilfeder 18 beaufschlagt die Ventilnadel 15 mittels der Druckplatte 16 mit einer Schließkraft, so dass der zwischen dem Ventilschließkörper 12 und der Ventilsitzfläche 11 gebildete Dichtsitz geschlossen ist. Ferner erzeugt die Ventilfeder 18 eine gewisse Vorspannung des piezoelektrischen Aktors 2.

Außerdem ist an dem Ventilgehäuse 3 ein Anschlusselement 20 ausgebildet, um eine elektrische Zuleitung an das Brennstoffeinspritzventil 1 anzuschließen. Die elektrische Zuleitung kann dabei mittels eines Steckers an elektrische Leitungen 21, 22 des Brennstoffeinspritzventils 1 angeschlossen werden. Die elektrischen Leitungen 21, 22 sind durch das Ventilgehäuse 3 und ein an den Aktorkörper 13 des Aktors 2 angefügtes Übergangsstück 23, das als Aktorfuß 23 ausgestaltet ist, an den Aktorkörper 13 geführt. An den Aktorkörper 13 des Aktors 2 ist auf der Seite der Druckplatte 16 außerdem ein Übergangsstück 24 angefügt, das als Aktorkopf 24 ausgestaltet ist. Über den Aktorkopf 24 wirkt der Aktorkörper 13 entgegen der Kraft der Ventilfeder 18 auf die Druckplatte 16 ein.

Der Aktorkörper 13 des piezoelektrischen Aktors 2 weist eine Vielzahl von keramischen Schichten 25, 26 27 und eine Vielzahl von zwischen den keramischen Schichten 25, 26, 27 angeordneten Elektrodenschichten 28, 29 auf. Dabei sind zur Vereinfachung der Darstellung nur die keramischen Schichten 25, 26, 27 und die Elektrodenschichten 28, 29 exemplarisch gekennzeichnet. Die Elektrodenschichten 28, 29 sind abwechselnd mit der elektrischen Leitung 21 und der elektrischen Leitung 22 verbunden. Beispielsweise sind die durch die Elektrodenschicht 28 repräsentierten Elektrodenschichten mit der elektrischen Leitung 21 verbunden, die die positiven Elektroden bilden können, und die durch die Elektrodenschicht 29 repräsentierten Elektrodenschichten sind mit der elektrischen Leitung 22 verbunden, die dann die negativen Elektroden bilden können.

Über die elektrischen Leitungen 21, 22 kann der piezoelektrische Aktor 2 geladen und entladen werden. Beim Laden des Aktors 2 dehnt sich der Aktorkörper 13 in Richtung der Achse 17 aus, so dass der zwischen dem Ventilschließkörper 12 und der Ventilsitzfläche 11 gebildete Dichtsitz geöffnet wird. Dadurch kann Brennstoff aus dem Brennstoffraum 7 über einen Ringspalt 35 und den geöffneten Dichtsitz abgespritzt werden. Beim Entladen des Aktors 2 zieht sich der Aktorkörper 13 wieder zusammen, so dass der zwischen dem Ventilschließkörper 12 und der Ventilsitzfläche 11 ausgebildete Dichtsitz geschlossen ist.

Die Verbindung der elektrischen Leitungen 21, 22 mit den Elektrodenschichten 28, 29 kann beispielsweise durch innenliegende Elektrodenanbindungen erfolgen.

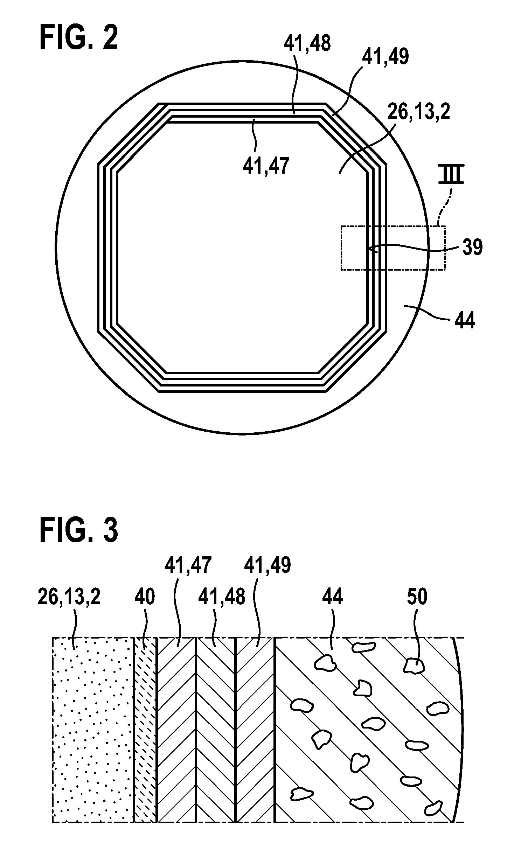

Der piezoelektrische Aktor 2 weist eine Außenfläche 38 auf. Zumindest auf die Außenfläche 38 des Aktorkörpers 13 ist eine elektrisch isolierende Beschichtung 40 (Fig. 3) aufgebracht, die beispielsweise aus einem Lack mit einer Dicke aus einem Bereich von 0,1 mm bis 0,2 mm gebildet sein kann. Die Beschichtung 40 erstreckt sich dabei über die gesamte Länge des Aktorkörpers 13 entlang der Achse 17. Um den beschichteten Aktorkörper 3 ist eine Schutzfolie 41 gewickelt, die aus zumindest einem Metall oder einer Metalllegierung gebildet ist. Die Schutzfolie 41 umwickelt ferner einen Teil 42 des Aktorfußes 23, der dem Aktorkörper 13 zugewandt ist, sowie einen Teil 43 des Aktorkopfes 24, der dem Aktorkörper 13 zugewandt ist. Somit umwickelt die metallische Schutzfolie 41 den gesamten Aktorkörper 13 an der mit der Beschichtung 40 versehenen Außenfläche 38, teilweise den Aktorfuß 23 und teilweise den Aktorkopf 24. Die Umwicklung des Aktorkörpers 13 mit der Schutzfolie 41 kann dabei in einem Zustand erfolgen, in dem der Aktorkörper 13 vorgespannt ist, wobei der Aktorkopf 24 und der Aktorfuß 23 bereits an den Aktorkörper 13 angefügt sind. Speziell kann der Aktorkörper 13, an den der Aktorfuß 23 und der Aktorkopf 24 angefügt sind, in einer geeigneten Vorrichtung vorgespannt und ausgerichtet werden, um die Schutzfolie 41 mehrmals um den Aktorkörper 13 zu wickeln, so dass ein Verband gebildet ist.

Außerdem ist eine Ummantelung 44 vorgesehen, die den mit der Schutzfolie 41 umwickelten Aktorkörper 13 ummantelt. Die Ummantelung 44 ummantelt außerdem den Teil 42 des Aktorfußes 23, der ebenfalls mit der Schutzfolie 41 ummantelt ist, sowie den Teil 43 des Aktorkopfes 24, der ebenfalls von der Schutzfolie 41 ummantelt ist. Ferner ummantelt die Ummantelung 44 noch einen weiteren Teil 45 des Aktorfußes 23 sowie einen weiteren Teil 46 des Aktorkopfes 24. Die Ummantelung 44 kann um den in der Vorrichtung fixierten Verband gespritzt werden. Dabei kann der Aktorkörper 13 weiterhin vorgespannt sein. Durch das Aufbringen der Ummantelung 44 ist der piezoelektrische Aktor 2 gebildet, der den mit der Beschichtung 40 beschichteten Aktorkörper 13, den Aktorkopf 24, den Aktorfuß 23, die Schutzfolie 41 und die Ummantelung 44 umfasst, wobei noch weitere Elemente vorgesehen sein können. Die Ummantelung 44 weist ein Grundmaterial auf der Basis eines teilelastischen Kunststoffes auf, so dass nach der Herstellung des piezoelektrischen Aktors 2 eine gewisse Vorspannung von der Ummantelung 44 auf den Aktorkörper 13 ausgeübt ist. Die Ventilfeder 18 kann dadurch im Hinblick auf die Vorspannung des piezoelektrischen Aktors 2 vereinfacht werden oder sogar ganz entfallen. Die Ummantelung 44 gewährleistet einen gewissen mechanischen Schutz für die Schutzfolie 41. Ferner gewährleistet die Ummantelung 44 eine Abdichtung der Schutzfolie 41 an den Schnittstellen zu dem Aktorfuß 23 sowie dem Aktorkopf 24. Dadurch ist eine hohe Widerstandsfähigkeit des piezoelektrischen Aktors 2 auch gegenüber einem unter hohen Druck stehenden Brennstoff, der im Aktorraum 5 vorgesehen ist, auch bei wechselnden Drücken und Temperaturen gewährleistet.

Fig. 2 zeigt den in Fig. 1 dargestellten piezoelektrischen Aktor 2 des Ausführungsbeispiels der Erfindung in einer Schnittdarstellung entlang der mit II bezeichneten Schnittlinie. Die metallische Schutzfolie 41 ist in mehreren Lagen 47, 48, 49 um die Außenfläche 39 des Aktorkörpers 13 des piezoelektrischen Aktors 2 gewickelt. Die metallische Schutzfolie 41 passt sich dabei zumindest im Wesentlichen an die Geometrie, insbesondere den in der Fig. 2 dargestellten Querschnitt, des Aktorkörpers 13 an. Die Dicke der metallischen Schutzfolie 41 kann aus einem Bereich von etwa 10 µm bis etwa 20 µm gewählt sein. Die um den mit der Schutzfolie 41 umwickelten Aktorkörper 13 gespritzte Ummantelung 44 kann unterschiedlich ausgestaltet sein und ermöglicht die Vorgabe der äußeren Form des piezoelektrischen Aktors 2, die in diesem Ausführungsbeispiel zumindest im Wesentlichen zylinderförmig ist.

Fig. 3 zeigt den in Fig. 2 mit III bezeichneten Ausschnitt eines piezoelektrischen Aktors 2 des Brennstoffeinspritzventils 1 des Ausführungsbeispiels der Erfindung. Die Ummantelung 44 weist ein Grundmaterial aus einem teilelastischen Kunststoff auf. Hierfür eignet sich insbesondere ein Polyamid, insbesondere Polyamid 66 (PA 66). Ferner weist die Ummantelung 44 wärmeleitende Zusatzstoffe 50 auf, von denen in der Fig. 3 exemplarisch der wärmeleitende Zusatzstoff 50 gekennzeichnet ist. Die wärmeleitenden Zusatzstoffe 50 können relativ feinteilig sein und dem Grundmaterial der Ummantelung 44 zugesetzt werden und/oder etwas großteiliger sein und in das Grundmaterial der Ummantelung 44 eingebettet sein. Die wärmeleitenden Zusatzstoffe 50 können aus einem Metall und/oder einem Silicium oder dergleichen gebildet sein. Durch die wärmeleitenden Zusatzstoffe 50 wird die Wärmeleitfähigkeit der Ummantelung 44 verbessert, so dass die beim Betrieb des piezoelektrischen Aktors 2 im Aktorkörper 13 entstehende Wärme besser abgeführt werden kann, beispielsweise an den im Aktorraum 5 vorgesehenen Brennstoff.

Die elektrisch isolierende Beschichtung 40 verhindert einen Kurzschluss zwischen den Elektrodenschichten 28, 29 des Aktorkörpers 13 und der metallischen Schutzfolie 41, insbesondere der Lage 47 der metallischen Schutzfolie 41.

Es ist anzumerken, dass zur Vereinfachung der Darstellung drei Lagen 47, 48, 49 der Schutzfolie 41 dargestellt sind. Es kann jedoch auch eine andere Anzahl an Lagen 47, 48, 49 vorgesehen sein, insbesondere können mehr als drei Lagen 47, 48, 49 vorgesehen sein.

Die Erfindung ist nicht auf das beschriebene Ausführungsbeispiel beschränkt.

## Patentansprüche

1. Piezoelektrischer Aktor (2), insbesondere Aktor für Brennstoffeinspritzventile, mit einem Aktorkörper (13), der eine Vielzahl von keramischen Schichten (25, 26, 27) und eine Vielzahl von zwischen den keramischen Schichten angeordneten Elektrodenschichten (28, 29) aufweist und zumindest einem an den Aktorkörper (13) angefügten Übergangsstück (23, 24),
**dadurch gekennzeichnet,**
**dass** zumindest eine Schutzfolie (41) vorgesehen ist, die um den Aktorkörper (13) gewickelt ist, dass eine Ummantelung (44) vorgesehen ist und dass die Ummantelung (44) den mit der Schutzfolie (41) umwickelten Aktorkörper (13) und zumindest teilweise das Übergangsstück (23, 24) ummantelt.

2. Piezoelektrischer Aktor nach Anspruch 1,
**dadurch gekennzeichnet,**
**dass** die Ummantelung (44) ein Grundmaterial auf der Basis zumindest eines teilelastischen Kunststoffs aufweist.

3. Piezoelektrischer Aktor nach Anspruch 2,
**dadurch gekennzeichnet,**
**dass** die Ummantelung (44) wärmeleitende Zusatzstoffe (50) aufweist, die dem Grundmaterial zugesetzt und/oder in das Grundmaterial eingebettet sind.

4. Piezoelektrischer Aktor nach Anspruch 3,
**dadurch gekennzeichnet,**
**dass** die wärmeleitenden Zusatzstoffe aus einem Metall und/oder einem Silicium gebildet sind.

5. Piezoelektrischer Aktor nach einem der Ansprüche 1 bis 4,
**dadurch gekennzeichnet,**
**dass** die Schutzfolie (41) um den Aktorkörper (13) und um einen an den Aktorkörper angrenzenden Teil des Übergangsstücks (23, 24) gewickelt ist und dass die Ummantelung (44) den mit der Schutzfolie (41) umwickelten Aktorkörper (13), den mit der Schutzfolie umwickelten Teil des Übergangsstücks (23, 24) und einen weiteren Teil des Übergangsstücks (23, 24) ummantelt.

6. Piezoelektrischer Aktor nach einem der Ansprüche 1 bis 5,
**dadurch gekennzeichnet,**
**dass** die Ummantelung (44) durch Umspritzen aufgebracht ist.

7. Piezoelektrischer Aktor nach einem der Ansprüche 1 bis 6,
**dadurch gekennzeichnet,**
**dass** die Schutzfolie (41) in mehreren Lagen (47, 48, 49) um den Aktorkörper (13) gewickelt ist.

8. Piezoelektrischer Aktor nach einem der Ansprüche 1 bis 7,
**dadurch gekennzeichnet,**
**dass** die Schutzfolie (41) als wärmeleitende Schutzfolie ausgebildet ist.

9. Piezoelektrischer Aktor nach Anspruch 8,
**dadurch gekennzeichnet,**
**dass** die Schutzfolie (41) als metallische Schutzfolie (41) ausgebildet ist.

10. Piezoelektrischer Aktor nach einem der Ansprüche 1 bis 9,
**dadurch gekennzeichnet,**
**dass** eine elektrisch isolierende Beschichtung (40) vorgesehen ist, die auf eine Außenfläche (38) des Aktorkörpers (13) aufgebracht ist, um die die Schutzfolie (41) gewickelt ist.

11. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 10 und einem von dem Aktor (2) betätigbaren Ventilschließkörper (12), der mit einer Ventilsitzfläche (11) zu einem Dichtsitz zusammenwirkt.
